**Europäisches Patentamt**

**European Patent Office**

**Office européen des brevets**

(19)

(11) Veröffentlichungsnummer : **0 129 763 B1**

(12) **EUROPÄISCHE PATENTSCHRIFT**

(45) Veröffentlichungstag der Patentschrift :
23.12.87

(51) Int. Cl.⁴ : **H 01 L 27/14, H 04 N 5/21**

(21) Anmeldenummer : 84106647.5

(22) Anmeldetag : 09.06.84

(54) **Übergabeschaltung für vom Hintergrundsignal befreite Nutzsignale eines IR-Detektors an einen CCD-Kanal.**

(30) Priorität : 18.06.83 DE 3322054

(43) Veröffentlichungstag der Anmeldung :
02.01.85 Patentblatt 85/01

(45) Bekanntmachung des Hinweises auf die Patenterteilung : 23.12.87 Patentblatt 87/52

(84) Benannte Vertragsstaaten :
BE DE FR GB IT NL

(56) Entgegenhaltungen :
US-A- 3 944 849
US-A- 3 969 634
US-A- 4 115 692
IEEE TRANSACTIONS ON ELECTRON DEVICES,
Band ED-29, Nr. 1, Januar 1982, Seiten 3-13, IEEE,
New York, US; K. CHOW u.a.: "Hybrid infrared focalplane arrays"
IEEE TRANSACTIONS ON ELECTRON DEVICES,
Band ED-27, Nr. 1, Januar 1980, Seiten 146-150, IEEE,
New York, US; H. TAKIGAWA u.a.: "Hybrid IRCCD
imaging array"
RCA REVIEW, Band 36, Nr. 3, September 1975, Seiten
566-593, Princeton, US; W.F. KOSONOCKY u.a.:
"Basic concepts of charge-coupled devices"

(73) Patentinhaber : **Licentia Patent-Verwaltungs-GmbH**
**Theodor-Stern-Kai 1**
**D-6000 Frankfurt/Main 70 (DE)**

(72) Erfinder : **Kohlbacher, Gerhard, Dipl.-Ing.**
**Im Grund 3**
**D-7900 Ulm 10 (DE)**
Erfinder : **Nothaft, Peter, Dr.**
**Neu-Ulmer-Strasse 16**
**D-7910 Neu-Ulm/Reutti (DE)**

(74) Vertreter : **Schulze, Harald Rudolf, Dipl.-Ing. et al**
**Licentia Patent-Verwaltungs-GmbH Theodor-Stern-**
**Kai 1**
**D-6000 Frankfurt/Main 70 (DE)**

## Beschreibung

Die Erfindung betrifft eine Übergabeschaltung für vom Hintergrundsignal befreite Nutzsignale eines IR-Detektors (Infrarot-Detektors) an einen CCD-Kanal (Charge-Coupled-Device-Kanal).

Neuzeitliche Wärmebild-Geräte besitzen zur Verbesserung der Empfindlichkeit eine Vielzahl von Einzeldetektoren in der Fokusebene der IR-Optik. Die Forderung nach einer hohen geometrischen Bildauflösung bedingt eine dichte, im allgemeinen zweidimensionale Packung der Detektorelemente. Da die IR-Detektoren eine Betriebstemperatur von typisch $40\,K < T < 100\,K$ erfordern, sind die ein- oder zweidimensionalen Detektorarrays in ein Dewargehäuse einzubauen.

Bei zweidimensionalen Multielementarrays ist dabei eine individuelle Herausführung der Signalleitungen von jedem Detektorelement zum zugehörigen Vorverstärker äußerst schwierig. Ein relativ einfaches Detektorsignal-Ausleseverfahren bieten die ladungsgekoppelten Bauelemente, auch CCD-Schieberegister genannt. CCD-Schieberegister wandeln die Vielzahl der räumlich verteilten Detektorsignale um in ein Zeit-Multiplex-Signal. Diese Parallel-Serien-Wandlung durch die CCD-Schieberegister ergibt eine beträchtliche Verringerung der elektrischen Durchführungen in das Dewargehäuse.

Das vom Detektor-Array auszuwertende Objekt weist üblicherweise eine nur geringe Temperaturdifferenz zu seiner Umgebung bzw. zum Hintergrund auf. Daher ist das der Temperaturdifferenz entsprechende Nutzsignal nur ein Bruchteil des Hintergrundsignals, z. b. 1/100 bis 1/1 000. Um den dynamischen Bereich der CCD-Schieberegister zu erhöhen, ist es notwendig, den vom Hintergrundsignal erzeugten Ladungsanteil vor dem Einlesen in das CCD-Schieberegister zu Subtrahieren. Vom CCD-Schieberegister wird dann nur noch ein dem Nutzsignal entsprechender Ladungsanteil weitergeleitet.

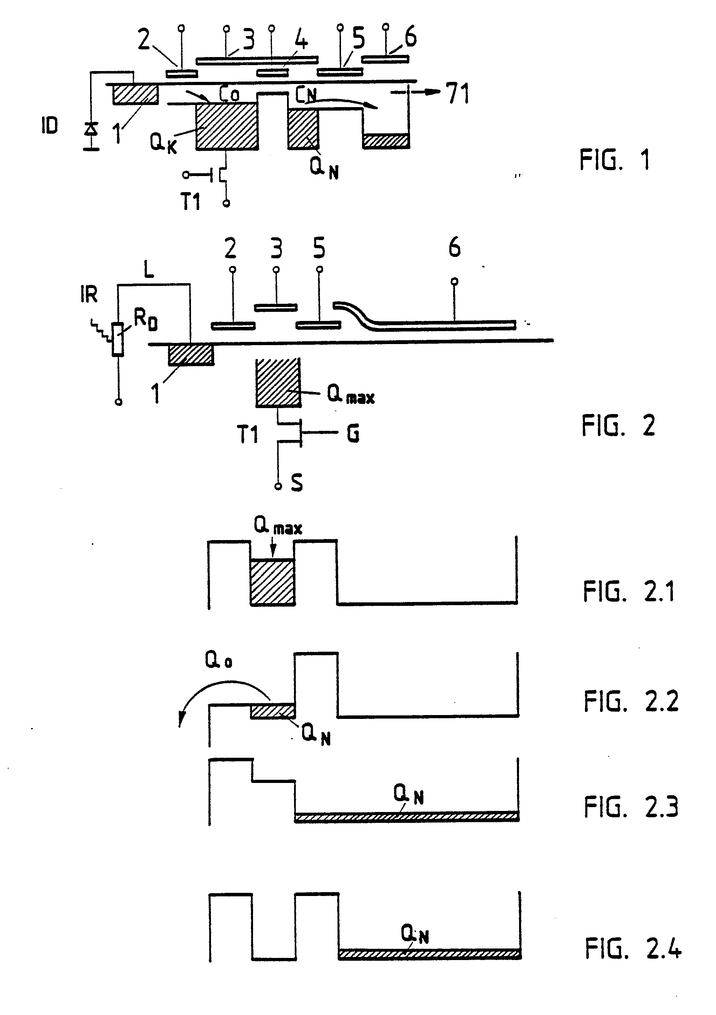

Als Beispiel für eine Hintergrundsignalunterdrückung ist in Fig. 1 eine Detektorsignal-Übergabeschaltung schematisch dargestellt, wie sie aus IEEE Transactions on Electron Devices, Vol. ED-29, No. 1, Jan. 1982, Seiten 3 bis 13 bekannt ist. Mit 1 ist ein leitend dotierter Bereich der Übergabeschaltung bezeichnet, der mit dem IR-Detektor ID in Verbindung steht. Unter einer Speicherelektrode 3 befindet sich ein Speicherbereich mit den Kapazitäten $C_O$ und $C_N$, die durch eine von einer Elektrode 4 erzeugten Potentialschwelle trennbar sind. Am Eingang des Speicherbereichs ist eine Elektrode 2 angeordnet und am Ausgang des Speicherbereichs eine Transferelektrode 5. Mit 6 ist die Eingangselektrode eines CCD-Schieberegisters 71 bezeichnet. Den Speicherbereich ist im Halbleiter-Chip, auf dem sich das CCD-Schieberegister befindet, als Drainbereich eines Feldeffekttransistors T1 realisiert. Diese in Fig. 1 dargestellte Übergabeschaltung erfordert entweder eine hohe zu jedem Detektorelement gehörige Speicherkapazität $C_O$, um die

während der Integrationszeit $t_O$ angefallene, vom Hintergrund- und Nutzsignal generierte Gesamtladung zu speichern. Erst am Ende der Integrationszeit kann ein dem Hintergrundsignal entsprechender konstanter Ladungsanteil $Q_K$ abgezogen und die verbleibende Ladung $Q_N$ über das CCD-Schieberegister 71 ausgelesen werden
oder

eine kurze Integrationszeit $\Delta t_{int}$, um die Speicherung der Gesamtladung auch in kleinerer Speicherkapazität $C_O$ vornehmen zu können.

Der erste Fall ist unerwünscht, weil große Speicherflächen (in Fig. 1 die Fläche der Elektrode 3) den Füllfaktor (das Verhältnis der Fläche des Sensor-Elements zur Fläche der Übergabeschaltung) reduzieren. Für den Fall einer photoneninduzierten Generationsrate der Ladungsträger von $2 \cdot 10^{16}\ cm^{-2}s^{-1}$, einer Integrationszeit von $\Delta t_{int} = 100\ \mu s$ und einer Gatespannung $U_3$ von 10 V ist die Gatefläche der Speicherelektrode 3 bereits gleich der Sensorfläche.

Der zweite Fall ist unerwünscht, weil er hohe Verschiebefrequenzen in der Übergabeschaltung und Taktfrequenzen für das CCD-Schieberegister erfordert. Außerdem wird durch die geringen Ladungsmengen auch das Signal/Rausch-Verhältnis wesentlich verschlechtert. Für den Fall einer Integrationszeit von $\Delta t_{int} = 10\ \mu s$ ergibt sich bei 100 Detektorelementen bereits eine CCD-Schieberegisterfrequenz von 10 MHz, weil Sensortotzeiten vermieden werden sollen. CCD-Schieberegister für hohe Frequenzen haben jedoch im allgemeinen einen geringeren dynamischen Bereich und erheblich schlechtere Transfereigenschaften.

Der Erfindung liegt die Aufgabe zugrunde, den Stand der Technik zu verbessern. Insbesondere soll ohne Verschlechterung des Signal/Rausch-Verhältnisses das Verhältnis Detektorfläche/(Fläche der Übergabeschaltung) verbessert werden.

Die Aufgabe wird durch die im Anspruch 1 genannte Erfindung gelöst. Es ist nunmehr möglich, mit einer einfachen Elektrodenkonfiguration zu arbeiten, wodurch Technologiefehler reduziert werden und damit eine höhere Ausbeute an IR-Auswerteschaltungen erzielt wird. Außerdem erfolgt nun das Abtrennen eines Konstanten Ladungsanteils (chargepartitioning), das Abziehen der Nutzsignalladung (skimming) und der Überstrahlungsschutz (anti-blooming) in einer einzigen Stufe und wird in einer überraschend einfachen Weise durchgeführt.

Wegen des geringen Platzbedarfs der Übergabeschaltung wird, wenn sie auf einem Halbleiterchip mehrfach vorgesehen wird, ein gutes Verhältnis IR-Detektorfläche/Gesamtfläche des Chips erzielt.

Die Erfindung wird nun anhand eines Ausführungsbeispiels näher erläutert. Hierzu zeigen im einzelnen :

Fig. 2 Die erfindungsgemäße Übergabeschaltung

Fig. 2.1 bis 2.4 Den jeweiligen Oberflächenpotentialverlauf zu vier aufeinanderfolgenden Zeitintervallen

In Fig. 2 ist aus Gründen der besseren Übersichtlichkeit eine hybride IR-Detektor-Übergabestufe mit CCD-Schieberegistereingang dargestellt. Hybrid bedeutet, daß die IR-Detektoren und die Übergabeschaltungen auf zwei voneinander getrennten Halbleiter-Chips, z. B. übereinander, angeordnet und durch Leitungsbrücken L miteinander verbunden sind. Mit $R_D$ ist ein IR-Detektor des Detektorchips bezeichnet. Sein Widerstand hängt von der IR-Bestrahlungsstärke ab. Die Elektroden 2 bis 6 sind in an sich bekannter Weise auf dem Halbleiter-Chip mit den Übergabeschaltungen angeordnet. Ein leitend dotierter Bereich 1 des Halbleiterchips ist mittels der Leitungsbrücke L mit einem IR-Detektor $R_D$ des Detektorchips verbunden.

Der Bereich unter der Speicherelektrode 3 ist als Drainbereich eines Feldeffekttransistors T1 realisiert. Die Speicherelektrode 3 und die Sourceelektrode S des Transistors T1 werden konstanten Potential gehalten.

Im Gegensatz zum in Fig. 1 gezeigten Stand der Technik wird eine vom IR-Detektor generierte Ladung nicht unter der Speicherelektrode 3 innerhalb einer Integrationszeit $\Delta t_{int}$ aufsummiert, sondern gemäß der Erfindung fließt durch einen kurzzeitigen Spannungsimpuls am Gate G des Transistors T1 in einem ersten Takt, wie Fig. 2.1 zeigt, zunächst eine Ladung $Q_{max}$ über den leitend gesteuerten Transistor T1 unter die Speicherelektrode 3. Der Betrag der Ladungsmenge $Q_{max}$ hängt von der gewählten, im Betrieb konstanten Sourcespannung des Transistors T1 ab. Der Speicherbereich unter der Elektrode 3 wird folglich bis zum Source-Potential aufgeladen. Die Fläche und die Breite der Speicherelektrode 3 ist so gewählt, das die gespeicherte Ladung $Q_{max}$ noch vom CCD-Schieberegister, dessen Eingang unter der Elektrode 6 liegt, zu verarbeiten ist.

In einem zweiten Takt wird nun, wie Fig. 2.2 zeigt, mittels der Entladeelektrode 2 der sich unter der Speicherelektrode 3 befindende Speicherbereich durch den belichtungsabhängigen Widerstand des IR-Detektors $R_D$ nach Maßgabe seiner Belichtung entladen. Dabei fließt die Ladungsmenge $Q_O$ ab. Die verbleibende Restladung $Q_N = Q_{max} - Q_O$ wird in einem dritten Takt als Nutzladung über die Transferelektrode 5 an den Eingang des CCD-Kanals, also unter die Elektrode 6, transferiert. Hierzu werden im dritten Takt die im zweiten Takt abgesenken Potentialschwellen unter den Elektroden 2 und 3 angehoben und die Potentialschwelle unter der Elektrode 5, wie Fig. 2.3 zeigt, abgesenkt.

Durch Anheben der Potentialschwelle unter der Elektrode 5 und Absenken der Potentialschwelle unter der Elektrode 3 wird der Zustand gemäß fig. 2.4 erreicht. Die Ladung $Q_N$ kann nun aus der CCD-Eingangsstufe, also dem Bereich unter der Elektrode 6, ausgelesen und über den Transistor T1 kann erneut eine Ladungsmenge $Q_{max}$ unter

die Speicherelektrode 3 eingegeben werden, so daß dann der Vorgang gemäß fig. 2.1, wie bereits beschrieben, erneut ablaufen kann.

Nach der Speicherung der je nach Anwendung vorzugebenden Ladung $Q_{max}$ wird das Potential an der Elektrode 2 für die Zeit $\Delta t_{int}$ jeweils auf einen derartigen, evtl. nachstellbaren oder automatisch nachregelbaren Wert eingestellt, daß bei den hellsten Bildteilen des IR-Bildes $Q_N = Q_{max} - Q_O = 0$ wird. Durch diese Maßnahme ist eine zusätzliche anti-blooming-Schaltung nicht erforderlich. Wird z. B. der IR-Detektor einer zu hohen Beleuchtung ausgesetzt, so kann nicht mehr als die gesamte über den Transistor T1 eingespeiste Ladung $Q_{max}$ über den Detektor $R_D$ abfließen. Am CCD-Eingang erscheint somit in diesem Fall das Signal « Null ».

Eine Schaltung zur Subtraktion des IR-Hintergrundsignals entfällt ebenfalls, da durch die konstante Hintergrundstrahlung eine diese entsprechende Grundladung über den Detektorwiderstand $R_D$ abgeführt wird. Auf diese Weise verbleibt die vom CCD-Schieberegister zu verarbeitende Signalladung $Q_N$ unter der Elektrode 3. Das Skimming-Verfahren ist somit automatisch realisiert.

Da diese einfache Schaltung nur wenig Platz beansprucht, kann sie mit Vorteil auf einem Halbleiter-Chip mehrfach vorgesehen werden. Selbst in monolithischer Ausführung, bei der IR-Detektoren und Übergabeschaltungen auf einem einzigen Halbleiter-Chip angeordnet sind, lassen sich dadurch gute Verhältnisse von Detektorfläche/Halbleiterchip-Fläche erzielen.

**Patentansprüche**

1. Übergabeschaltung für vom Hintergrundsignal befreite Nutzsignale eines IR-Detektors an einen CCD-Kanal (Charge-Coupled-Device-Kanal) mit einem Speicherbereich unter einer Speicherelektrode (3), der als Drainbereich eines Feldeffekttransistors (T1) realisiert ist, mit einer Elektrode (2) am Eingang des Speicherbereichs und mit einer Transferelektrode (5) am Ausgang des Speicherbereichs, bei der der Speicherbereich in einem ersten Takt über den leitend gesteuerten Transistor (T1) bis zum Source-Potential des Transistors aufgeladen wird, in einem zweiten Takt mittels der Elektrode (2) am Eingang des Speicherbereichs und dem IR-Detektor ($R_D$) nach Maßgabe der Belichtung des Detektors entladen wird und in einem dritten Takt die Restladung des Speicherbereichs als Nutzladung über die Transferelektrode (5) an den Eingang (6) des CCD-Kanals transferiert wird.

2. Übergabeschaltung nach Anspruch 1, dadurch gekennzeichnet, daß sie auf einem Halbleiterchip mehrfach vorgesehen ist.

**Claims**

1. Transfer circuit for intelligence signals, freed from background signal, of an infrared detector to a charge-coupled-device channel with a storage region which is below a storage electrode (3) and realised as drain region of a field effect transistor (T1), with an electrode (2) at the input of the storage region and with a transfer electrode (5) at the output of the storage region, in which the storage region is charged in a first time element by way of the transistor (T1), driven into conductive state, up to the source potential of the transistor, is discharged in a second time element by means of the electrode (2) at the input of the storage region and the infrared detector in accordance with the illumination of the detector and the remaining charge of the storage region is transferred in a third time element as useful intelligence charge by way of the transfer electrode (5) to the input (6) of the charge-coupled-device channel.

2. Transfer circuit according to claim 1, characterised thereby, that it is provided several times on a semiconductor chip.

**Revendications**

1. Circuit de transfert à un canal CCD des signaux utiles d'un détecteur IR débarrassé du bruit propre, avec une région de stockage sous une électrode de stockage (3) réalisée sous forme du drain d'un transistor à effet de champ (T1), une électrode (2) à l'entrée de la région de stockage et une électrode de transfert (5) à la sortie de la région de stockage, ledit circuit étant caractérisé en ce que la région de stockage est, pendant une première impulsion d'horloge, chargée par le transistor (T1) à l'état passant, jusqu'au potentiel de source de ce dernier ; au cours d'une seconde impulsion d'horloge, l'électrode (2) disposée à l'entrée de la région de stockage et le détecteur IR ($R_D$) déchargent ladite région en fonction de l'exposition lumineuse du détecteur ; et pendant une troisième impulsion d'horloge, la charge résiduelle de la région de stockage est transférée sous forme de charge utile par l'électrode de transfert (5) à l'entrée (6) du canal CCD.

2. Circuit de transfert selon revendication 1, caractérisé par sa répétition sur une pastille semiconductrice.

FIG. 1

FIG. 2

FIG. 2.1

FIG. 2.2

FIG. 2.3

FIG. 2.4